# EUROPEAN PATENT SPECIFICATION

(11) **EP 3 834 227 B1**
(45) Date of publication and mention of the grant of the patent: **04.09.2024**
(21) Application number: 18938731.9
(22) Date of filing: 30.10.2018
(51) Int. Cl.: H01L 23/31, H01L 21/56, H01L 23/16, H01L 23/433, H01L 23/544, H01L 25/065, H01L 21/98, H01L 23/488, H01L 23/48, H01L 23/49, H01L 21/60

(54) **IC PACKAGE**
IC-GEHÄUSE
BOÎTIER DE CIRCUIT INTÉGRÉ

(43) Date of publication of application: 16.06.2021
(73) Proprietor: Yangtze Memory Technologies Co., Ltd., Wuhan, Hubei 430000 (CN)
(72) Inventor: ZHOU, Houde, Wuhan, Hubei 430000 (CN); CHEN, Peng, Wuhan, Hubei 430000 (CN)
(74) Representative: Lippert Stachow Patentanwälte Rechtsanwälte
(86) International application number: PCT/CN2018/112567
(87) International publication number: WO 2020/087253

(56) References cited:
- CN-A- 101 452 825
- CN-A- 101 926 001
- CN-A- 103 530 679
- CN-A- 105 895 624
- JP-B2- 3 904 934
- US-A1- 2006 113 663
- US-A1- 2006 231 944
- US-A1- 2009 001 561
- US-A1- 2010 175 912
- US-A1- 2014 015 148
- US-A1- 2014 077 352
- US-A1- 2014 077 352
- US-A1- 2016 005 682
- US-A1- 2016 005 696

## Description

### BACKGROUND

In semiconductor manufacturing, integrated circuit (IC) packaging is a step in the semiconductor device fabrication that encapsulates one or more semiconductor dies (also referred to as IC chips) of integrated circuits in a supporting case that prevents physical damage, corrosion and the like. The supporting case with the encapsulated semiconductor die(s) is referred to as an IC package. The IC package can be laser-marked for identification and traceability.
An integrated circuit (IC) package comprising a package substrate, one or more IC chips that are interconnected with the package substrate, a metal or metal alloy plate, the plate having a first major surface and a second major surface, while the marking plate being stacked on the one or more IC chips with the first major surface facing the one or more IC chips is in general disclosed in US 2016/005682 A1 and in US 2006/113663 A1. An integrated circuit (IC) package as described above further comprising a plastic structure configured to encapsulate the one or more IC chips and the plate is described in US 2014/015148 A1. US 2016/005696 A1 discloses a silicon marking plate, i.e. the marking plate having an equal coefficient of thermal expansion as the one or more IC chips, but does not disclose the marking plate having a stair structure and the first major surface of the marking plate being smaller than the second major surface. US 2006/231944 A1 discloses a marking plate in an IC package, the marking plate having a stair structure, but is silent on the marking plate having an equal coefficient of thermal expansion as the one or more IC chips. US 2009/001561 A1 discloses laser marking on the surface of a heat sink exposed at the package surface.

### BRIEF SUMMARY

The present invention is set out in the appended claims 1-11.

In some examples not forming part of the claimed invention, the marking plate is formed of at least one of a ceramic material, a metal material, a metal alloy material In an embodiment, the marking plate is formed of a semiconductor material.

In an embodiment, the IC package includes a plurality of bond wires that are configured to interconnect the one or more IC chips to the package substrate. The plastic structure is configured to encapsulate the plurality of bond wires.

It is noted that in an embodiment, the IC package is one of a ball grid array (BGA) package, a quad-flat package (QFP), a quad flat non-lead (QFN) package, a land grid array (LGA) package, and a pin grid array (PGA).

In some embodiments, neighboring IC chips are staggered and multiple IC chips in the IC package are stacked in a zig-zag pattern.

According to an aspect of the disclosure, the marking plate has a better anti-laser penetration property than the plastic structure. In some embodiments, the marking plate has a higher rigidity than the plastic structure. According to another aspect of the disclosure, the marking plate has a better thermal conductivity than the plastic structure. Thus, the marking plate can transfer heat generated by the IC chips during operation to the outer surface of the IC package.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to dimensions of the various features may be arbitrarily increased or reduced for clarity of discussion.
Fig. 1 shows a cross-sectional view of an integrated circuit (IC) package 100 in accordance with some embodiments.
Fig. 2 shows a cross-sectional view of another IC package 200, which does not form an embodiment of the claimed subject matter, not being part of the invention.
FIG. 3 shows a flow chart outlining a process example 300 according to an embodiment of the disclosure.
Figs. 4-6 show cross-sectional views of the IC package 100 during a fabrication process in accordance with some embodiments.

### DETAILED DESCRIPTION

The following disclosure provides many different embodiments, or examples, for implementing different features of the provided subject matter. Specific examples of components and arrangements are described below to simplify the present disclosure. These are, of course, merely examples. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

Aspects of the disclosure provide an integrated circuit(IC) package with a marking plate embedded in a plastic structure. The marking plate has a higher rigidity than the molding material of the plastic structure, and has a better anti-laser penetration property than the molding material. Because of the higher rigidity, the IC package distortion due to high temperature processing, such as a soldering process, can be reduced. Further, because of the better anti-laser penetration property, a relatively thinner marking plate is allowed. Thus, the IC package can have a relatively small thickness or can encapsulate more IC chips without increasing the package thickness.

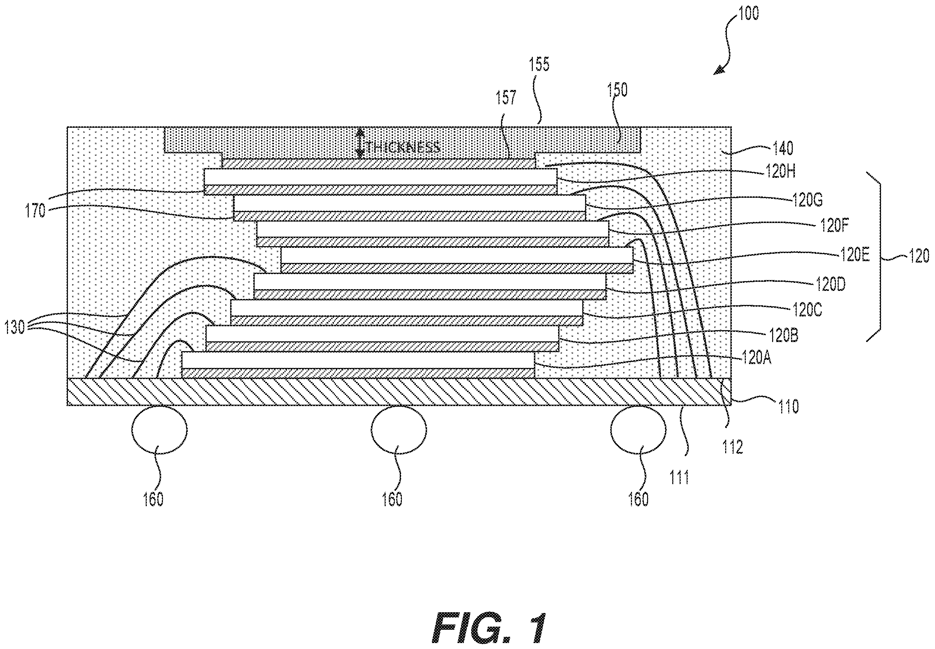

Fig. 1 shows a cross-sectional view of an integrated circuit (IC) package 100 in accordance with some embodiments. The IC package 100 includes a package substrate 110, a plurality of IC chips 120 (e.g., including IC chips 120A-120H in Fig. 1) and a marking plate 150. The IC chips 120 are stacked on the package substrate 110 and are encapsulated in a plastic structure 140. The marking plate 150 is stacked on the IC chips 120 and is embedded in the plastic structure 140. A surface 155 of the marking plate 150 is a portion of the outer surface of the IC package 100 and the surface 155 can be laser-marked for identification and traceability.

The package substrate 110 is made, for example, of suitable insulating material (also referred to as dielectric material), such as an epoxy based laminate substrate, a resin-based Bismaleimide-Triazine (BT) substrate, and the like. The package substrate 110 is relatively rigid to provide mechanical support to the IC chips 120. The package substrate 110 has a first surface 111 and a second surface 112. The IC chips 120 are disposed on a surface, such as the second surface 112 of the package substrate 110.

The package substrate 110 also provides electrical support for the IC chips 120. In some examples, the package substrate 110 includes multiple layers of metal traces, such as copper wires, and the like with the insulating material in between. The metal traces on the different layers can be connected by vias. Further, contact structures are formed on both the first surface 111 and the second surface 112 to electrically interface the IC chips 120 in the IC package 100 to components out of the IC package 100.

The IC chips 120 can be any suitable chips. The IC chips 120 include various circuits for providing storage, computing and/or processing functionalities.

The package substrate 110 provides interconnects from the inputs/outputs of the IC chips 120 to the contact structures that are formed on the first surface 111 and the second surface 112 of the IC package 100. In an example, the IC chips 120 includes input/output (I/O) pads (not shown) that are electrically connected to internal circuits that are formed on the IC chips 120. Bond wires 130 (e.g. aluminum wires, copper wires, silver wires, gold wires and the like) are bonded to connect the I/O pads on the IC chips 120 and the contact structures on the second surface 112 of the package substrate 110 to form electrical connections between the IC chips 120 and the package substrate 110. In Fig. 1, neighboring IC chips in the IC chips 120 are staggered to provide bonding space to allow the bond wires 130 to be bonded on the I/O pads, and avoid shorting circuit. Further, the IC chips 120 are stacked in a zig-zag pattern to provide space for bond wires 130.

The package substrate 110 also includes suitable contact structures 160 on the first surface 111. In Fig. 1, the IC package 100 is a ball grid array (BGA) package, and each of the contact structures 160 includes a solder pad and a solder ball that is deposited on the solder pad. It is noted that, in some examples, the solder balls are not formed on the package substrate 110. In an embodiment, the IC package is a quad-flat package (QFP). In another embodiment, the IC package 100 is a quad flat non-lead (QFN) package. In another embodiment, the IC package 100 is a land grid array (LGA) package, and each of the contact structures includes a solder pad. In another embodiment, the IC package 100 is a pin grid array (PGA) package, and each of the contact structures 160 includes a pin.

In Fig. 1, the package substrate 110, the plastic structure 140 and the marking plate 150 form the outer portion of the IC package 100 that encapsulates the IC chips 120 inside. Specifically, the marking plate 150 is stacked on the IC chips 120. Then, the second surface 112 of the package substrate 110, the IC chips 120 and the bond wires 130 are encapsulated by the plastic structure 140. The marking plate 150 is embedded in the plastic structure 140 with the surface 155 exposed for laser-marking.

The plastic structure 140 is formed of any suitable material, such as silica fillers, resin, and the like. In an example, the plastic structure 140 includes epoxy molding compound (EMC). The plastic structure 140 and IC chips 120 have different coefficient thermal expansions (CTE) (also referred to as CTE mismatch), and have different thermal conductivity.

According to an aspect of the disclosure, the marking plate 150 is formed of a material that has a higher rigidity than the plastic structure 140. In Fig. 1, the IC package 100 includes the marking plate 150, the IC chips 120 and the package substrate 110 from the upper surface (e.g., the surface 155 of the marking plate 150) to the bottom surface (e.g., the first surface 111 of the package substrate 110). The marking plate 150, the IC chips and the package substrate 110 have relatively high rigidity than the plastic structure 140. In a conventional example, the upper portion of a related IC package is also made of EMC, and is used for laser-marking. Compared to the conventional example, the IC package 100 has lower volume percentage of EMC, and thus has higher package rigidity than the conventional example.

The marking plate 150 has about the same CTE (e.g., matching CTE) as the IC chips 120. Thus, the IC package 110 has a reduced warpage during thermal processing. For example, CTE mismatch can cause package warpage during thermal processing after molding. For example, the IC packages can be mounted on a printed circuit board (PCB) using a surface mount process. The surface mount process includes a solder reflow step that raises a processing temperature, for example, above 200°C. When the processing temperature returns to for example room temperature, the IC package 100 has reduced warpage compared to the conventional example due to the matching CTE from the upper surface to the bottom surface.

The marking plate 150 has a better anti-laser penetration property than the plastic structure 140 to prevent laser penetration. A laser penetration depth in the marking plate 150 is shorter than a laser penetration depth in the plastic structure 140. Thus, the IC package 100 has a reduced thickness or can include more IC chips 120. For example, in the conventional example, because the laser-marking is marked on the EMC, to prevent laser damages to the circuits on the IC chips 120 and to the bond wires 130, the top portion of the plastic package above the IC chips needs to be relatively thick, such as about 150 µm. The marking plate 150 has a better anti-laser penetration property than the plastic structure 140, and a thickness of 30 µm is enough to prevent laser damage to the circuits on the IC chips 120 and the bond wires 130.

According to another aspect of the disclosure, the marking plate 150 has a better thermal conductivity than the plastic structure 140. For example, the marking plate 150 can transfer heat generated by the IC chips during operation to the outer surface of the IC package 100 faster than the plastic structure 140. The fast heat transfer can provide proper thermal environment for the IC chips 120, reduce chip temperature during operation, and allow the IC chips 120 to perform properly during operation.

In an embodiment, the marking plate 150 is formed of silicon, such as pure silicon, and is then referred to as a mirror die (due to shining surface 155) in an example. Thus, the marking plate 150 has about the same CTE (e.g., matching CTE) as the IC chips 120, and has a higher rigidity and better anti-laser penetration property than the plastic structure 140.

It is noted that in examples not forming part of the claimed invention, other suitable material, such as ceramic, metal, metal alloy can be used to form the marking plate 150. In an example, the marking plate 150 is formed of ceramic material. In another example, the marking plate 150 is formed of metal alloy. The marking plate 150 is suitably processed such that the bottom surface of the marking plate 150 that faces the IC chips 120 is electrically non-conductive to avoid shorting to the bond wires 130.

The marking plate 150 is configured to have a stair shape at the cross-sectional view. Thus, the surface 157 of the marking plate 150 that faces the IC chip 120H is smaller than the surface 155 of the marking plate 150. The smaller surface 157 provides more space for wire-bonding on the IC chip 120H. The larger surface 155 allows more area for laser markings.

It is noted that while the IC chips 120 are shown with the same chip size in Fig. 1, the IC chips 120 can have different chip sizes in other examples.

It is also noted that when stacking IC chips 120 and the marking plate 150, intermediate layers 170, such as adhesive films, polymer films, spacer films, and the like can be used between the IC chips 120 and the marking plate 150.

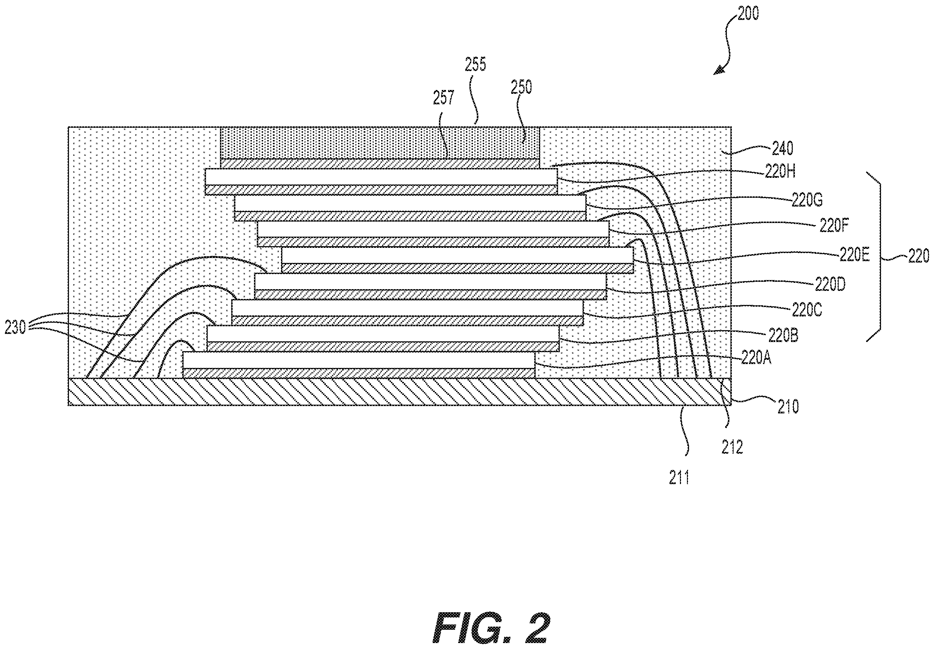

Fig. 2 shows a cross-sectional view of another IC package 200 in accordance with some examples, not being part of the invention. Similar to the IC package 100, the IC package 200 includes a package substrate 210, a plurality of IC chips 220 and a marking plate 250. The IC chips 220 are stacked on the package substrate 210 and are encapsulated in a plastic structure 240. The marking plate 250 is stacked on the IC chips 220 and is embedded in the plastic structure 240. A surface 255 of the marking plate 250 is a portion of the outer surface of the IC package 200 and the surface 255 can be laser-marked for identification and traceability.

The IC package 200 utilizes certain components that are identical, equivalent or similar to those used in the IC package 100. For example, the IC chips 220 are equivalent or similar to the IC chips 120. The bond wires 230 are equivalent or similar to the bond wires 130. The plastic structure 240 is equivalent or similar to the plastic structure 140. The package substrate 210 is equivalent or similar to the package substrate 110. The description of these components has been provided above and will be omitted here for clarity purposes.

In the Fig. 2 example, the marking plate 250 is configured to have a rectangular cuboid shape, and have a rectangular shape in the cross-sectional view, thus the surface 257 that faces the IC chip 220H is of the same surface area as the surface 255 that is a portion of the outer surface of the IC package 200.

Further, in the Fig. 2 example, the IC package 200 can be a LGA package without soldering balls. The package substrate 210 includes flat contact structures on the first surface 211.

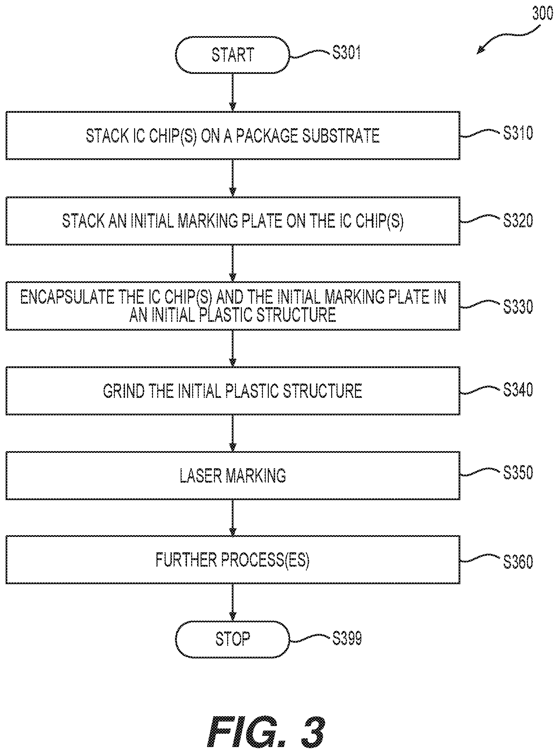

Fig. 3 shows a flow chart outlining a process 300 for fabrication according some embodiments of the disclosure. In an embodiment, the process 300 is used to fabricate the IC package 100.

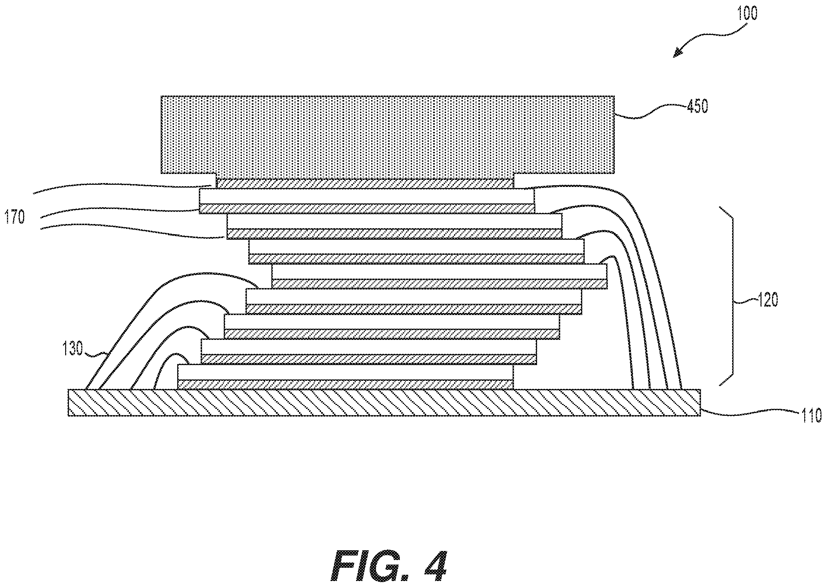

Figs. 4-6 show various cross sectional views of the IC package 100 at intermediate stages during the process 300 in accordance with some embodiments. It is noted that suitable modifications can be made on the Figs. 4-6 for other IC package, such as the IC package 200.

Referring to Fig. 3 and Fig. 4, the process starts at S301, and proceeds to S310.

At S310, IC chips are stacked on a package substrate. As shown in Fig. 4, the plurality of IC chips 120 are stacked on the package substrate 110. The IC chips 120 are stacked in a staggered manner to provide more space for wire bonding. In an embodiment, neighboring IC chips in the IC chips 120 area staggered to provide space for wire bonding. The IC chips 120 can be stacked in a zig-zag pattern. Then bond wires 130 are bonded to interconnect the IC chips 120 to the package substrate 110. Fig. 4, adhesive films 170 are used between the neighboring IC chips 120.

At S320, an initial marking plate is stacked on the IC chips. As shown in Fig. 4, an initial marking plate 450 is stacked on the IC chips 120. It is noted that the initial marking plate 450 is thicker than the marking plate 150 in the IC package 100. In Fig. 4, an adhesive film 170 is used between the initial marking plate 450 and the top of IC chips 120.

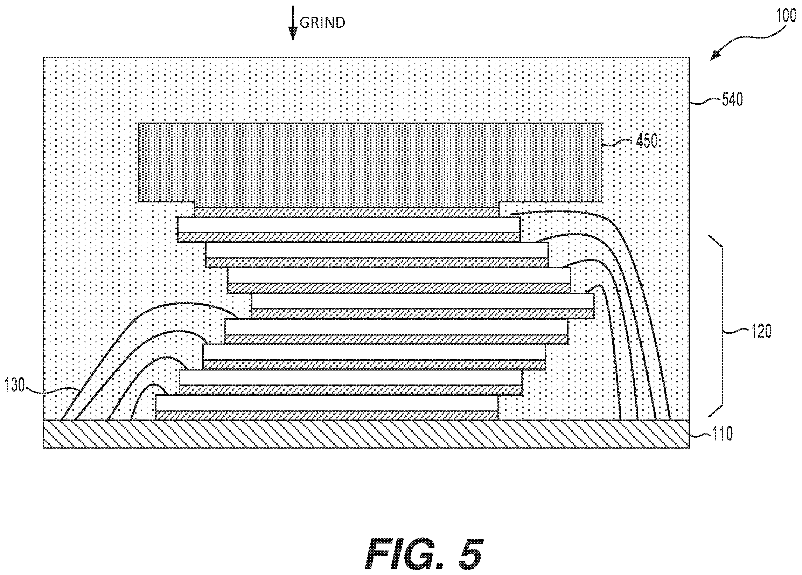

At S330, the initial marking plate and the IC chips are encapsulated in an initial plastic structure. As shown in Fig. 5, plastic material, such as EMC and the like is molded to form the initial plastic structure 540 that encapsulates the IC chips 120 and the initial marking plate 450.

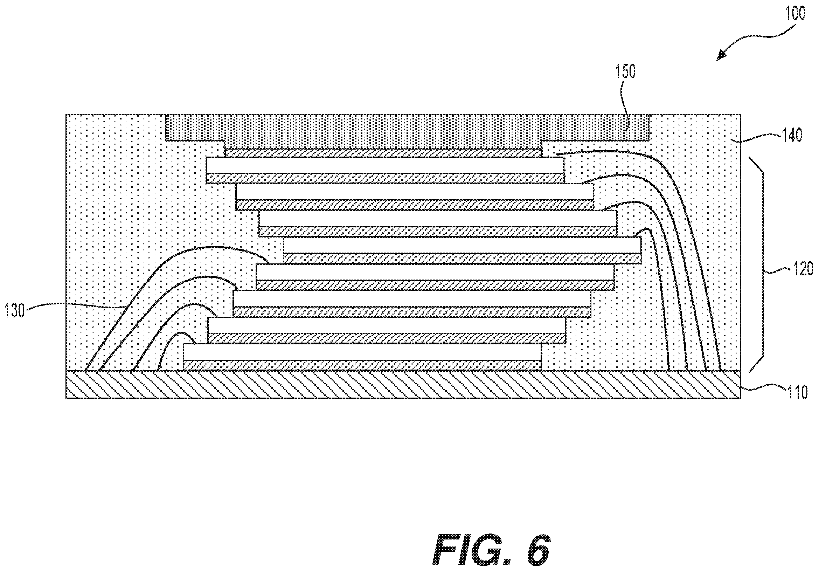

At S340, the initial plastic structure is grinded. As shown in Fig. 5, the initial plastic structure 540 is grinded to expose the initial marking plate 450, and further grinded to form the plastic structure 140 and the marking plate 150. Fig. 6 shows the IC package after the grinding process.

At S350, the IC package is laser marked on the marking plate. For example, laser marking can be performed on the marking plate 150 for identification and traceability.

At S360, further process(es) can be performed on the IC package. In an example, solder balls, such as the solder balls 160 are attached to the package substrate 110. In an example, the IC packaging is performed in the form of a matrix array of packages. The matrix array of packages can be diced to form individual IC packages. The individual IC packages can then be tested and sorted. Then, the process proceeds to S399 and terminates.

The foregoing outlines features of several embodiments so that those skilled in the art may better understand the aspects of the present disclosure. Those skilled in the art should appreciate that they may readily use the present disclosure as a basis for designing or modifying other processes and structures for carrying out the same purposes and/or achieving the same advantages of the embodiments introduced herein.

## Claims

1. An integrated circuit, IC, (100) package, comprising:
a package substrate (110);
one or more IC chips (120) that are interconnected with the package substrate (110);
a marking plate (150), suitable for being laser marked or being laser marked, having a first major surface and a second major surface, the marking plate (150) being stacked on the one or more IC chips (120) with the first major surface facing the one or more IC chips and the marking plate (150) has a stair structure;
a plastic structure (140) configured to encapsulate the one or more IC chips (120) and the marking plate (150) with the second major surface of the marking plate (150) being a portion of an outer surface of the IC package (120), wherein
a laser penetration depth in the marking plate is shorter than a laser penetration depth in the plastic structure (140), and wherein
the first major surface of the marking plate is smaller than the second major surface, **characterized by** the marking plate (150) having an equal coefficient of thermal expansion, CTE, as the one or more IC chips (120).

2. The IC package (100) of claim 1, wherein the marking plate (150) is formed of a semiconductor material.

3. The IC package (100) of claim 1, wherein a plurality of bond wires (130) are configured to interconnect the one or more IC chips (120) to the package substrate (110); and the plastic structure (140) is configured to encapsulate the plurality of bond wires (130).

4. The IC package (100) of claim 1, wherein the IC package is one of a ball grid array, BGA, package, a quad-flat package, QFP, a quad flat non-lead, QFN, package, a land grid array, LGA, package, and a pin grid array, PGA.

5. The IC package (100) of claim 1, wherein neighboring IC chips in the one or more IC chips are staggered to provide space for bond wires.

6. The IC package (100) of claim 1, wherein the marking plate (150) has a higher rigidity than the plastic structure (140).

7. A method for fabricating an integrated circuit, IC, package (100), comprising:
stacking one or more IC chips (120) on a package substrate (110);
forming a marking plate (150) on the one or more IC chips (120) with a first major surface facing the one or more IC chips (120) and wherein the marking plate (150) has is a stair structure; and
forming a plastic structure (140) that encapsulates the one or more IC chips (120) and the marking plate (150) with a second major surface of the marking plate (150) being a portion of an outer surface of the IC package (100); and
laser-marking on the second major surface of the marking plate (150), wherein a laser penetration depth in the marking plate is shorter than a laser penetration depth in the plastic structure (140), and
wherein forming the marking plate (150) on the one or more IC chips (120) further comprises:
forming the marking plate (150) with the first major surface that is smaller than the second major surface, **characterized by**
the marking plate (150) having an equal coefficient of thermal expansion, CTE, as the one or more IC chips (120).

8. The method of claim 7, wherein forming the marking plate (150) and the plastic structure (140) further comprises:
encapsulating an initial marking plate (450) and the one or more IC chips (120) in an initial plastic structure (540); and
grinding the initial plastic structure (540) and the initial marking plate (450) to expose the second major surface of the marking plate (150).

9. The method of claim 7, further comprising:
providing bonding wires (130) to interconnect the one or more IC chips (120) to the package substrate (110); and
forming the plastic structure (110) comprises encapsulating the bonded wires (130).

10. The method of claim 7, wherein stacking the one or more IC chips (120) on the package substrate (110) further comprises: staggering neighboring IC chips (120) in the one or more IC chips to provide space for bond wires (130).

11. The method of claim 7, wherein: the marking plate (150) has a higher rigidity than the plastic structure (140).

## Patentansprüche

1. Gehäuse für integrierte Schaltungen, IC-Gehäuse,(100), umfassend:
ein Gehäusesubstrat (110);
einen oder mehrere IC-Chips (120), die mit dem Gehäusesubstrat (110) verbunden sind;
eine Markierungsplatte (150), die für eine Lasermarkierung geeignet ist oder lasermarkiert ist, mit einer ersten Hauptfläche und einer zweiten Hauptfläche, wobei die Markierungsplatte (150) mit der dem einen oder den mehreren IC-Chips zugewandten Hauptfläche auf dem einen oder den mehreren IC-Chips (120) gestapelt ist und wobei die Markierungsplatte eine Treppenstruktur aufweist;
eine Kunststoffstruktur (140), die ausgebildet ist zum Einkapseln des einen oder der mehreren IC-Chips (120) und der Markierungsplatte (150), wobei die zweite Hauptfläche der Markierungsplatte (150) ein Teil einer Außenfläche des IC-Gehäuses (120) ist, wobei
eine Lasereindringtiefe in die Markierungsplatte kürzer ist als eine Lasereindringtiefe in die Kunststoffstruktur (140) und wobei
die erste Hauptfläche der Markierungsplatte kleiner ist als die zweite Hauptfläche der Markierungsplatte,
**dadurch gekennzeichnet, dass** die Markierungsplatte (150) einen gleichen Wärmeausdehnungskoeffizienten, CTE, wie der eine oder die mehreren IC-Chips (120) aufweist.

2. IC-Gehäuse (100) nach Anspruch 1, wobei die Markierungsplatte (150) aus einem Halbleitermaterial gebildet ist.

3. IC-Gehäuse (100) nach Anspruch 1, wobei eine Mehrzahl von Bonddrähten (130) ausgebildet ist zum Verbinden des einen oder der mehreren IC-Chips (120) mit dem Gehäusesubstrat (110); und die Kunststoffstruktur (140) ausgebildet ist zum Einkapseln der mehreren Bonddrähte (130).

4. IC-Gehäuse (100) nach Anspruch 1, wobei das IC-Gehäuse eines der folgenden Gehäuse ist: ein Ball Grid Array, BGA, Package, ein Quad Flat Package, QFP, ein Quad Flat No Leads, QFN, Package, ein Land Grid Array, LGA, Package und ein Pin Grid Array, PGA, Package.

5. IC-Gehäuse (100) nach Anspruch 1, wobei die benachbarten IC-Chips in dem einen oder den mehreren IC-Chips gestaffelt sind, um Raum für die Bonddrähte zu schaffen.

6. IC-Gehäuse (100) nach Anspruch 1, wobei die Markierungsplatte (150) eine höhere Festigkeit aufweist als die Kunststoffstruktur (140).

7. Verfahren zur Herstellung eines Gehäuses für integrierte Schaltungen, IC-Gehäuse, (100), umfassend:
Stapeln eines oder mehrerer IC-Chips (120) auf einem Gehäusesubstrat (110);
Bilden einer Markierungsplatte (150) auf dem einen oder den mehreren IC-Chips (120), wobei eine erste Hauptfläche dem einen oder den mehreren IC-Chips (120) zugewandt ist und wobei die Markierungsplatte (150) eine Treppenstruktur aufweist; und
Bilden einer Kunststoffstruktur (140), die den einen oder die mehreren IC-Chips (120) und die Markierungsplatte (150) einkapselt, wobei eine zweite Hauptfläche der Markierungsplatte (150) ein Teil einer Außenfläche des IC-Gehäuses (100) ist; und
Lasermarkieren auf der zweiten Hauptfläche der Markierungsplatte (150), wobei
eine Lasereindringtiefe in die Markierungsplatte kürzer ist als eine Lasereindringtiefe in die Kunststoffstruktur (140) und wobei
das Bilden der Markierungsplatte (150) auf dem einen oder den mehreren IC-Chips (120) ferner umfasst:
Ausbilden der Markierungsplatte (150) mit der ersten Hauptfläche, die kleiner ist als die zweite Hauptfläche, **dadurch gekennzeichnet, dass** die Markierungsplatte (150) einen gleichen Wärmeausdehnungskoeffizienten, CTE, wie der eine oder die mehreren IC-Chips (120) aufweist.

8. Verfahren nach Anspruch 7, wobei das Bilden der Markierungsplatte (150) und der Kunststoffstruktur (140) ferner umfasst:
Einkapseln einer Ausgangsmarkierungsplatte (450) und des einen oder der mehreren IC-Chips (120) in einer Ausgangskunststoffstruktur (540); und
Schleifen der Ausgangskunststoffstruktur (540) und der Ausgangsmarkierungsplatte (450) zur Freilegung der zweiten Hauptfläche der Markierungsplatte (150).

9. Verfahren nach Anspruch 7, ferner umfassend:
Bereitstellen von Bonddrähten zur Verbindung des einen oder der mehreren IC-Chips (120) mit dem Gehäusesubstrat (110); wobei
das Bilden der k(110) das Einkapseln der gebondeten Drähte (130) umfasst.

10. Verfahren nach Anspruch 7, wobei das Stapeln des einen oder der mehreren IC-Chips (120) auf dem Gehäusesubstrat (110) ferner umfasst:
Staffeln von benachbarten IC-Chips (120) in dem einen oder den mehreren IC-Chips, um Raum für die Bonddrähte (130) zu schaffen.

11. Verfahren nach Anspruch 7, wobei:
die Markierungsplatte (150) eine höhere Festigkeit aufweist als die Kunststoffstruktur (140).

## Revendications

1. Boîtier de circuit intégré, boîtier de CI, (100) comprenant:
un substrat de boîtier (110);
une ou plusieurs puces de CI (120) connectées au substrat de boîtier (110);
une plaque de marquage (150) adaptée pour un marquage au laser ou marquée au laser, ayant une première surface principale et une deuxième surface principale, la plaque de marquage (150) étant empilée avec la surface principale faisant face à une ou plusieurs puces de CI sur une ou plusieurs puces de CI (120), la plaque de marquage ayant une structure en escalier;
une structure en plastique (140) configurée pour encapsuler la ou les puces de CI (120) et la plaque de marquage (150), la deuxième surface principale de la plaque de marquage (150) étant une partie d'une surface extérieure du boîtier de CI (120), dans lequel
une profondeur de pénétration du laser dans la plaque de marquage est plus courte qu'une profondeur de pénétration du laser dans la structure en plastique (140), et dans lequel la première surface principale de la plaque de marquage est plus petite que la deuxième surface principale de la plaque de marquage,
**caractérisé en ce que** la plaque de marquage (150) a le même coefficient de dilatation thermique, CTE, que les une ou plusieurs puces de CI (120).

2. Boîtier de CI (100) selon la revendication 1, dans lequel la plaque de marquage (150) est formée d'un matériau semiconducteur.

3. Boîtier de CI (100) selon la revendication 1, dans lequel une pluralité de fils de connexion (130) est formée pour connecter la ou les puces de CI (120) au substrat de boîtier (110); et la structure en plastique (140) est formée pour encapsuler la pluralité de fils de connexion (130).

4. Boîtier de CI (100) selon la revendication 1, dans lequel le boîtier de CI est l'un des boîtiers suivants: un Ball Grid Array, BGA, package, un Quad Flat Package, QFP, un Quad Flat No Leads, QFN, package, un Land Grid Array, LGA, package et un Pin Grid Array, PGA, package.

5. Boîtier de CI (100) selon la revendication 1, dans lequel les puces de CI adjacentes dans la ou les puces de CI sont échelonnées pour fournir un espace pour les fils de connexion.

6. Boîtier de CI (100) selon la revendication 1, dans lequel la plaque de marquage (150) présente une rigidité supérieure à celle de la structure en plastique (140).

7. Procédé de fabrication d'un boîtier de circuit intégré, boîtier de CI, (100), comprenant:
empiler une ou plusieurs puces de CI (120) sur un substrat de boîtier (110);
former une plaque de marquage (150) sur la ou les puces de CI (120), une première surface principale faisant face à la ou aux puces de CI (120) et la plaque de marquage (150) ayant une structure en escalier; et
former une structure en plastique (140) encapsulant la ou les puces de CI (120) et la plaque de marquage (150), une seconde surface principale de la plaque de marquage (150) faisant partie d'une surface extérieure du boîtier de CI (100); et
le marquage au laser sur la deuxième surface principale de la plaque de marquage (150),
une profondeur de pénétration du laser dans la plaque de marquage étant plus courte qu'une profondeur de pénétration du laser dans la structure en plastique (140), et
la formation de la plaque de marquage (150) sur la ou les puces de CI (120) comprenant en outre:
former la plaque de marquage (150) avec la première surface principale qui est plus petite que la deuxième surface principale,
**caractérisé en ce que** la plaque de marquage (150) a un coefficient de dilatation thermique, CTE, identique à celui de la ou des puces de CI (120).

8. Procédé selon la revendication 7, dans lequel la formation de la plaque de marquage (150) et de la structure en plastique (140) comprend en outre:
encapsuler une plaque de marquage initiale (450) et la ou les puces de CI (120) dans une structure en plastique initiale (540); et
broyer la structure en plastique initiale (540) et la plaque de marquage initiale (450) pour exposer la deuxième surface principale de la plaque de marquage (150).

9. Procédé selon la revendication 7, comprenant en outre:
fournir des fils de connexion pour connecter la ou les puces de CI (120) au substrat de boîtier (110);
la formation de la structure en plastique (110) comprenant l'encapsulation des fils connectés (130).

10. Procédé selon la revendication 7, dans lequel l'empilement de l'une ou des plusieurs puces de CI (120) sur le substrat de boîtier (110) comprend en outre:
empiler des puces de CI (120) adjacentes parmi la ou les puces de CI afin de fournir un espace pour les fils de connexion (130).

11. Procédé selon la revendication 7, dans lequel:
la plaque de marquage (150) présente une rigidité supérieure à celle de la structure en plastique (140).
